# EUROPÄISCHE PATENTANMELDUNG

(11) **EP 3 351 944 A1**
(43) Veröffentlichungstag der Anmeldung: **25.07.2018**
(21) Anmeldenummer: 18305040.0
(22) Anmeldetag: 19.01.2018
(51) Int. Cl.: G01R 22/06, G01R 11/04

(54) **ADAPTERVORRICHTUNG ZUM MECHANISCHEN UND ELEKTRISCHEN VERBINDEN EINES ELEKTRONISCHEN ELEKTRIZITÄTSZÄHLERS MIT EINER BEFESTIGUNGS- UND KONTAKTIEREINRICHTUNG EINES ZÄHLERPLATZES**

(30) Priorität: 20.01.2017 DE 102017101147
(71) Anmelder: Hager Electro GmbH & Co. KG, 66440 Blieskastel (DE)
(72) Erfinder: ANNA, Felix, 66424 HOMBURG (DE); ZIMMERMANN, Michael, 66399 MANDELBACHTAL (DE)
(74) Vertreter: Nuss, Laurent

(57) **Zusammenfassung**

Die Erfindung betrifft eine Adaptervorrichtung (10) zum mechanischen und elektrischen Verbinden eines elektronischen Elektrizitätszählers (120) mit einer Befestigungs- und Kontaktiereinrichtung (100) eines Zählerplatzes sowie eine Elektrizitätszählereinheit umfassend einen elektronischen Elektrizitätszähler (120) und eine Adaptervorrichtung (10) nach der Erfindung. Eine Strommesseinrichtung der Adaptervorrichtung (10) ist geeignet, ein elektrisches Signal und/oder ein Funksignal und/oder ein optisches Signal dem Elektrizitätszähler (120) bereit zu stellen, welches die in einem elektrischen Leitelement (62) der Adaptervorrichtung fließende Stromstärke abbildet.

## Beschreibung

Die Erfindung betrifft eine Adaptervorrichtung zum mechanischen und elektrischen Verbinden eines elektronischen Elektrizitätszählers mit einer Befestigungs- und Kontaktiereinrichtung eines Zählerplatzes.

Zählerplätze sind häufig mit sogenannten Befestigungs- und Kontaktiereinrichtungen versehen, die insbesondere zur Aufnahme eines elektronischen Elektrizitätszählers dienen. Solche Befestigungs- und Kontaktiereinrichtungen werden in der Regel an einer Zählertragplatte einer Zählerplatzbaueinheit befestigt und können mit Kontaktelementen versehen sein, die sich mit Anschlusselementen des Elektrizitätszählers verbinden lassen und die in einer elektrischen/elektromagnetischen Wirkverbindung mit Leitern stehen, die durch die Befestigung- und Kontaktiereinrichtung geführt sind.

Zur Messung des in diesen Leitern fließenden Stroms kann eine Strommesseinrichtung, vorzugsweise ein Stromwandler vorgesehen sein, der auf einer ersten Signalleitung ein elektrisches Signal bereitstellt, welches die in dem entsprechenden Leiter fließende Stromstärke abbildet.

Einerseits kann die Strommesseinrichtung Bestandteil des Elektrizitätszähler sein, so dass der zu zählende Strom durch den Elektrizitätszähler geführt wird, damit die Strommesseinrichtung das elektrische Signal bereitstellen kann, wie aus der EP 1 659 411 B1 bekannt, oder Bestandteil der Befestigungs-und Kontaktiereinrichtung sein, wo es das elektrische Signal ausgehend von der in der Leitung fließenden Stromstärke an einem Anschluss der Befestigung- und Kontaktiereinrichtung bereitstellt, wie aus DE 10 2013 002 010 A1 bekannt.

Elektronische Elektrizitätszähler neuerer Bauart können ohne Strommesseinrichtung ausgeführt sein und daher für die Montage an eine Befestigungs- und Kontaktiereinrichtung geeignet sein, welche wenigstens eine solche Strommesseinrichtung aufweist (vgl. DE 10 2013 002 010 A1). Elektrizitätszähler neuerer Bauart ohne Strommesseinrichtung können um eine Vielfaches kompakter ausgestaltet sein als Elektrizitätszähler neuerer Bauart mit Strommesseinrichtung, dass heiß dass Elektrizitätszähler neuerer Bauart ohne Strommesseinrichtung mit einer Bauhöhe versehen sein können, die ca. einem Drittel der Bauhöhe des Elektrizitätszählers neuerer Bauart mit Strommesseinrichtung entspricht.

Daher können solche elektronischen Elektrizitätszähler neuer Bauart daher nicht geeignet sein, an Befestigungs- und Kontaktiereinrichtungen ohne Stromwandler angeschlossen zu werden.

Es ist die Aufgabe der vorliegenden Erfindung, eine Adaptervorrichtung vorzuschlagen, die den Anschluss eines elektronischen Elektrizitätszählers an eine ohne Stromwandler ausgeführte Befestigungs- und Kontaktiereinrichtung ermöglicht.

Diese Aufgabe wird durch eine Adaptervorrichtung nach Anspruch 1 gelöst. Die erfindungsgemäße Adaptervorrichtung dient zum mechanischen und elektrischen Verbinden eines elektronischen Elektrizitätszählers mit einer Befestigungs- und Kontaktiereinrichtung eines Zählerplatzes. Die erfindungsgemäße Adaptervorrichtung umfasst
eine erste Befestigungsfläche zur Befestigung des elektronischen Elektrizitätszählers,
eine zweite Befestigungsfläche zur Befestigung an der Befestigungs-und Kontaktiereinrichtung,
wenigstens zwei erste Kontaktelemente, die von der zweiten Befestigungsfläche vorstehen und die jeweils mit einem Anschlusselement der Befestigungs- und Kontaktiereinrichtung verbindbar sind,
wenigstens ein elektrisches Leitelement, welches die zwei ersten Kontaktelemente elektrisch leitend miteinander verbindet, und
wenigstens eine Strommesseinrichtung, welche benachbart zu dem elektrischen Leitelement angeordnet ist.

Die Strommesseinrichtung ist geeignet, ein elektrisches Signal und/oder ein Funksignal und/oder ein optisches Signal dem Elektrizitätszähler bereit zu stellen, welches die in dem elektrischen Leitelement fließende Stromstärke abbildet.

Durch die erfindungsgemäße Adaptervorrichtung kann ein ohne Strommesseinrichtung ausgeführter elektronischer Elektrizitätszähler mit einer ohne Strommesseinrichtung ausgeführten Befestigungs- und Kontaktiereinrichtung eines Zählerplatzes verbunden werden. Die erfindungsgemäße Adaptervorrichtung ermöglicht es, bei einem Austausch eines Elektrizitätszählers älterer Bauart mit Strommesseinrichtung durch einen elektronischen Elektrizitätszähler neuer Bauart (ohne Strommesseinrichtung) ein Austauschen der Befestigungs- und Kontaktiereinrichtung entbehrlich zu machen.

Vorzugsweise ist die Strommesseinrichtung als Stromwandler ausgebildet.

Vorzugsweise umfasst die Adaptervorrichtung wenigstens eine Signalübertragungseinrichtung, wobei die Strommesseinrichtung eine erste Signalleitung umfasst, die elektrisch leitend mit der Signalübertragungseinrichtung verbunden ist, wobei die Strommesseinrichtung geeignet ist, auf der ersten Signalleitung ein elektrisches Signal bereit zu stellen, welches die in dem elektrischen Leitelement fließende Stromstärke abbildet, und wobei die Signalübertragungseinrichtung geeignet ist, anhand des elektrischen Signals ein Funksignal und/oder ein optisches Signal zu erzeugen, welches die in dem elektrischen Leitelement fließende Stromstärke abbildet und welches von einer Empfangseinrichtung des Elektrizitätszählers Empfangen werden kann.

Vorzugsweise umfasst die Adaptervorrichtung wenigstens zwei zweite Kontaktelemente, die jeweils mit einem Anschlusselement des elektronischen Elektrizitätszählers verbindbar sind, wobei die Strommesseinrichtung eine erste Signalleitung umfasst, die mit den wenigstens zwei zweiten Kontaktelementen elektrisch leitend verbunden ist, wobei die Strommesseinrichtung geeignet ist, auf der ersten Signalleitung ein elektrisches Signal bereit zu stellen, welches die in dem elektrischen Leitelement fließende Stromstärke abbildet, wobei die Adaptervorrichtung an der ersten Befestigungsfläche eine Öffnung aufweist, die derart ausgebildet ist, dass eine die Anschlusselemente des elektronischen Elektrizitätszählers aufweisende Anschlussleiste beim Befestigen des elektronischen Elektrizitätszählers mit der ersten Befestigungsfläche in die Öffnung einführbar ist, um die zweiten Kontaktelemente mit den Anschlusselementen des Elektrizitätszählers elektrisch leitend zu Verbinden.

In einer bevorzugten Ausgestaltung des elektronischen Elektrizitätszählers und der erfindungsgemäßen Adaptervorrichtung sind der elektronische Elektrizitätszähler und die Adaptervorrichtung derart ausgebildet, dass der elektronische Elektrizitätszähler mittels Aufsetzen und Verschieben auf der ersten Befestigungsfläche ohne die Verwendung eines Werkzeugs mit der ersten Befestigungsfläche verbunden werden kann.

Vorzugsweise ist die erste Befestigungsfläche mit wenigstens einer Ausnehmung versehen, in welche wenigstens ein Hakenelement des elektronischen Elektrizitätszählers eingreifen kann, um den elektronischen Elektrizitätszähler mit der ersten Befestigungsfläche zu befestigen. Vorzugsweise dienen das Hakenelement des elektronischen Elektrizitätszählers und die Ausnehmung der Adaptervorrichtung zur mechanischen Führung des elektronischen Elektrizitätszählers in einer im Wesentlichen parallel zur ersten Befestigungsfläche in vertikaler Richtung verlaufenden Führungsrichtung.

Vorzugsweise sind die erste Befestigungsfläche und die Öffnung derart ausgebildet, dass der elektronische Elektrizitätszähler durch eine Verschiebebewegung parallel und/oder entlang der ersten Befestigungsfläche mechanisch mit der ersten Befestigungsfläche verbindbar ist.

In einer bevorzugten Ausgestaltung sind die zweiten Kontaktelemente derart ausgebildet, dass die Anschlusselemente des elektronischen Elektrizitätszählers durch eine Verschiebebewegung parallel und/oder entlang der ersten Befestigungsfläche jeweils elektrisch leitend mit einem der zweiten Anschlusselemente verbindbar sind.

Diese Ausgestaltung vereinfacht sowohl das mechanische als auch das elektrisch leitende Verbinden des elektronischen Elektrizitätszählers mit der Adaptervorrichtung.

Vorzugsweise erstrecken sich die zweiten Kontaktelemente im Wesentlichen entlang einer Richtung, die im Wesentlichen parallel zur ersten Befestigungsfläche verläuft.
Diese Ausgestaltung ermöglicht das in Kontakt bringen der zweiten Kontaktelemente mit den Anschlusselementen des elektronischen Elektrizitätszählers durch einfaches Verschieben des elektronischen Elektrizitätszählers entlang der ersten Befestigungsfläche in einer parallel zu dieser verlaufenden Richtung.

In einer bevorzugten Ausgestaltung sind die zweiten Kontaktelemente als Kontakthülsen ausgebildet, in welche stiftförmige Anschlusselemente des elektronischen Elektrizitätszählers aufnehmbar sind, um die zweiten Kontaktelemente elektrisch leitend mit den Anschlusselementen des elektronischen Elektrizitätszählers zu verbinden.

Diese Ausgestaltung erlaubt ein einfaches und sicheres Verbinden der zweiten Kontaktelemente mit dem Anschlusselement des elektronischen Elektrizitätszählers.

In einer bevorzugten Ausgestaltung umfasst die Adaptervorrichtung ein Aufnahmeelement zur Aufnahme eines durch eine Aufnahme des elektronischen Elektrizitätszählers und/oder durch eine Aufnahme der Befestigungs- und Kontaktiereinrichtung geführten Plombierungsbolzens, wobei das Aufnahmeelement an der ersten Befestigungsfläche angeordnet ist und geeignet ist, den Plombierungsbolzen derart aufzunehmen, dass der elektronische Elektrizitätszähler gegen eine Verschiebung in einer im Wesentlichen parallel zur ersten Befestigungsfläche verlaufenden Richtung auf der ersten Befestigungsfläche gehalten ist und/oder die Adaptervorrichtung gegen eine Verschiebung in einer im Wesentlichen parallel zur zweiten Befestigungsfläche verlaufenden Richtung auf der Befestigungs- und Kontaktiereinrichtung gehalten ist.

Alternativ oder zusätzlich kann das Aufnahmeelement der Adaptervorrichtung zur Aufnahme eines durch eine Aufnahme einer Blindplatte und/oder durch eine Aufnahme der Befestigungs- und Kontaktiereinrichtung geführten Plombierungsbolzens, wobei das Aufnahmeelement an der ersten Befestigungsfläche angeordnet ist und geeignet ist, den Plombierungsbolzen derart aufzunehmen, dass die Blindplatte gegen eine Verschiebung in einer im Wesentlichen parallel zur ersten Befestigungsfläche verlaufenden Richtung auf der ersten Befestigungsfläche gehalten ist und/oder die Adaptervorrichtung gegen eine Verschiebung in einer im Wesentlichen parallel zur zweiten Befestigungsfläche verlaufenden Richtung auf der Befestigungs- und Kontaktiereinrichtung gehalten ist.

Diese Ausgestaltung ermöglicht mittels des Plombierungsbolzens den elektronischen Elektrizitätszähler sicher in seiner Position auf der Adaptervorrichtung und die Adaptervorrichtung sicher auf der Befestigungs- und Kontaktiereinrichtung zu halten.

Vorzugsweise umfasst die Adaptervorrichtung ein Verhakungselement, das von der zweiten Befestigungsfläche vorspringt und geeignet ist, einen Abschnitt der Befestigungs- und Kontaktiereinrichtung zu hintergreifen, um die zweite Befestigungsfläche und/oder die Adaptervorrichtung mechanisch mit der Befestigungs- und Kontaktiereinrichtung zu verbinden.
Diese Ausgestaltung ermöglicht ein einfaches und sicheres Verbinden der Adaptervorrichtung mit der Befestigungs- und Kontaktiereinrichtung.

In einer bevorzugten Ausgestaltung sind die ersten Kontaktelemente als Kontaktmesser ausgebildet, die in Kontaktöffnungen der Befestigungs- und Kontaktiereinrichtung durch eine Einführbewegung in einer im Wesentlichen orthogonal zur zweiten Befestigungsfläche verlaufenden Einführrichtung einführbar sind und durch eine Verschiebebewegung im Wesentlichen orthogonal zur Einführrichtung elektrisch leitend mit den Anschlusselementen der Befestigungs- und Kontaktiereinrichtung verbindbar sind.

Diese Ausgestaltung ermöglicht ein einfaches und sicheres elektrisch leitendes Verbinden der ersten Kontaktelemente mit den Anschlusselementen der Befestigungs- und Kontaktiereinrichtung.

Die Erfindung betrifft ferner eine Elektrizitätszählereinheit umfassend einen elektronischen Elektrizitätszähler und eine erfindungsgemäße Adaptervorrichtung. Der elektronische Elektrizitätszähler ist an der ersten Befestigungsfläche befestigt, wobei eine Anschlusselemente des Elektrizitätszählers aufweisende Anschlussleiste des elektronischen Elektrizitätszählers in die Öffnung eingeführt ist und die zweiten Kontaktelemente der Adaptervorrichtung mit den Anschlusselementen des Elektrizitätszählers elektrisch leitend verbunden sind.

Vorzugsweise weist die Adaptervorrichtung jeweils zwei erste Kontaktelemente und zwei zweite Kontaktelemente für jede zu messende Stromphase auf.

In einer weiteren bevorzugten Ausgestaltung kann die Adaptervorrichtung mit wenigstens einem dritten Kontaktelement versehen sein, das mit einem Phasenleiter verbindbar ist, um die in dem Phasenleiter vorherrschende Spannung zu führen. Vorzugsweise steht das dritte Kontaktelement von der zweiten Befestigungsfläche vor. Weiterhin vorzugsweise umfasst die Adaptervorrichtung wenigstens ein drittes Kontaktelement für jede einzelne Stromphase.

Vorzugsweise kann die Adaptervorrichtung mit wenigstens einem vierten Kontaktelement versehen sein, das mit dem dritten Kontaktelement verbunden ist, um die in dem Phasenleiter vorherrschende Spannung an dem vierten Kontaktelement dem Elektrizitätszähler bereit zu stellen. Vorzugsweise steht das vierte Kontaktelement von der ersten Befestigungsfläche vor. Weiterhin vorzugsweise umfasst die Adaptervorrichtung wenigstens ein viertes Kontaktelement für jede einzelne Stromphase bzw. jedes einzelne dritte Kontaktelement.

Alternativ oder zusätzlich kann das elektrische Signal und/oder das Funksignal und/oder das optische Signal ferner die an der jeweiligen Stromphase anliegende Spannung abbilden.

Vorzugsweise ist das dritte Kontaktelement mit einem Spannungswandler verbunden, der eine zweite Signalleitung umfasst, auf welcher ein Signal bereit gestellt werden kann, dass die in dem dritten Kontaktelement vorherrschende Spannung abbildet und/oder die dritte Spannung aufweist.

In einer bevorzugten Ausgestaltung ist das dritte Kontaktelement und/oder die zweite Signalleitung mit der ersten Signalleitung verbunden.

Vorzugsweise dient die Adaptervorrichtung zum mechanischen und elektrischen Verbinden eines elektronischen Elektrizitätszählers, der zur Messung eines dreiphasigen Stroms geeignet ist, mit der Befestigungs- und Kontaktiereinrichtung des Zählerplatzes.

In einer alternativen Ausgestaltung dient die Adaptervorrichtung zum mechanischen und elektrischen Verbinden eines elektronischen Elektrizitätszählers, der zur Messung eines einphasigen Stroms geeignet ist, mit der Befestigungs- und Kontaktiereinrichtung des Zählerplatzes.

In einer bevorzugten Ausgestaltung ist die Adaptervorrichtung mit drei Strommesseinrichtungen versehen, wobei jeweils eine der Strommesseinrichtungen an seiner ersten Signalleitung ein elektrisches Signal bereitstellt, welches eine Stromstärke des in einem Phasenleiter fließenden Stroms abbildet.

Einzelheiten und weitere Vorteile der erfindungsgemäßen Adaptervorrichtung werden anhand des nachfolgend beschriebenen Ausführungsbeispiels erläutert. Dabei veranschaulichen im Einzelnen:
Fig. 1: zeigt eine Befestigungs- und Kontaktiereinrichtung eines Zählerplatzes;

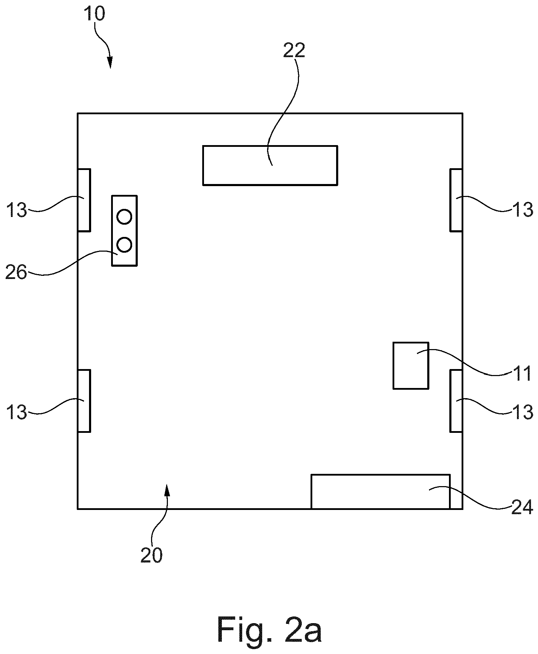

Fig. 2: zeigt eine schematische Darstellung einer Adaptervorrichtung nach einem Ausführungsbeispiel, welche an der Befestigungs- und Kontaktiereinrichtung befestigt werden kann;
Fig. 2a: zeigt eine Draufsicht auf eine erste Befestigungsfläche der in Fig. 2 wiedergegebenen Adaptervorrichtung;
Fig. 3: zeigt einen elektronischen Elektrizitätszähler, der ohne eine Strommesseinrichtung ausgebildet ist und der an einer ersten Befestigungsfläche der Adaptervorrichtung nach dem Ausführungsbeispiel befestigt werden kann;
Fig. 4. zeigt eine Anschlussleiste des in Fig. 3 gezeigten Elektrizitätszählers.

Die Erfindung betriff eine Adaptervorrichtung 10 zum mechanischen und elektrischen Verbinden eines elektronischen Elektrizitätszählers 120 mit einer Befestigungs- und Kontaktiereinrichtung 100 eines Zählerplatzes.

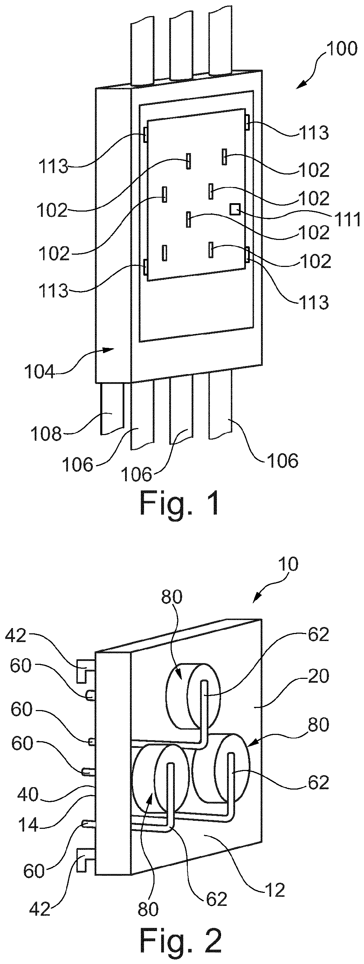

Die in Figur 1 wiedergegebene Befestigungs- und Kontaktiereinrichtung 100 umfasst ein Gehäuse 104, durch welches hindurch drei Phasenleiter 106 geführt sind. Zusätzlich kann durch das Gehäuse 104 ebenfalls ein Neutralleiter 108 hindurch geführt sein. Die Phasenleiter 106 und/oder der Neutralleiter 108 stehen mit Anschlusselementen der Befestigungs- und Kontaktiereinrichtung 100 in elektrisch leitendem Kontakt. Die Anschlusselemente der Befestigungs- und Kontaktiereinrichtung 100 sind hinter Kontaktöffnungen 102 der Befestigungs- und Kontaktiereinrichtung 100 angeordnet. Die Kontaktöffnungen 102 können an einer Vorderseite des Gehäuses 104 angeordnet sein und sind vorzugsweise schlitzförmig ausgebildet. Eine solche Befestigungs- und Kontaktiereinrichtung 100 ist ebenfalls aus der Druckschrift DE 10 2012 110 519 A1 bekannt.

Eine solche Befestigungs- und Kontaktiereinrichtung 100 ist zur Aufnahme eines elektromechanischen oder eines elektronischen Elektrizitätszählers ausgebildet.

Die in Figur 1 wiedergegebene Befestigungs- und Kontaktiereinrichtung 100 dient dazu, den elektromechanischen oder elektronischen Elektrizitätszähler elektrisch leitend mit den Phasenleitern 106 und/oder dem Neutralleiter 108 zu verbinden. Insbesondere ist die in Figur 1 gezeigt der Befestigungs- und Kontaktiereinrichtung 100 ohne Strommesseinrichtung ausgeführt, weshalb er zur Aufnahme von elektromechanischen oder elektronischen Elektrizitätszählern geeignet ist, die ihrerseits mit einer oder mehreren Strommesseinrichtungen versehen sind.

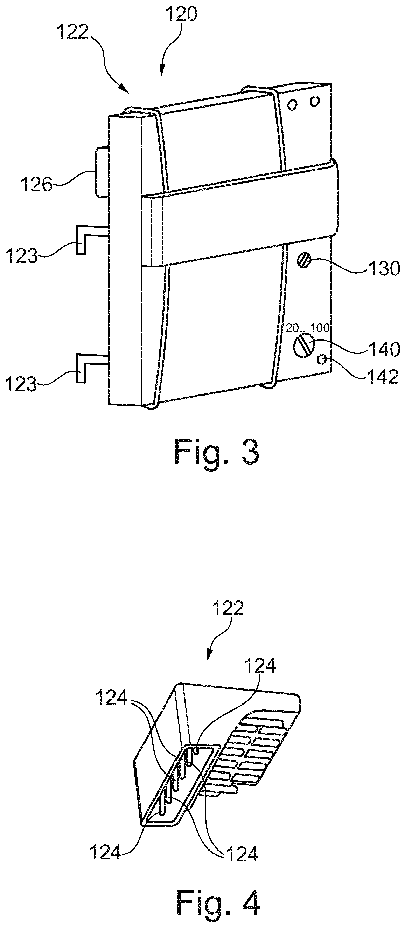

Figur 3 zeigt einen elektronischen Elektrizitätszähler 120 neuer Bauart, der eine Vielzahl an Anschlusselementen 124 aufweist. Wie insbesondere Fig. 4 wiedergibt, sind die Anschlusselemente 124 entlang einer Anschlussleiste 122 angeordnet und verlaufen vorzugsweise in einer sich im Wesentlichen parallel zu einer Rückseite des elektronischen Elektrizitätszählers 120 verlaufenden Richtung.

Die Anschlusselemente 124 des elektronischen Elektrizitätszählers 120 sind durch eine Verschiebebewegung parallel und/oder entlang einer Vorderseite einer Befestigungs- und Kontaktiereinrichtung neuerer Bauart (figürlich nicht wiedergegeben) mit der Befestigungs- und Kontaktiereinrichtung verbindbar.

Vorzugsweise sind die Anschlusselemente 124 des elektronischen Elektrizitätszählers 120 stiftförmig ausgebildet und sind beispielsweise in Anschlusselementen der Befestigungs- und Kontaktiereinrichtung aufnehmbar, um die Anschlusselemente der Befestigungs- und Kontaktiereinrichtung neuerer Bauart elektrisch leitend mit den Anschlusselementen 124 des elektronischen Elektrizitätszählers 120 zu verbinden.

Der elektronische Elektrizitätszähler 120 kann mit Hakenelementen 126 versehen sein, die in seitlichen Ausnehmungen der Befestigungs- und Kontaktiereinrichtung neuerer Bauart eingreifen und die mechanische Führung in vertikaler Richtung ermöglichen. Mittels eines Plombierungsbolzens 130 kann der elektronische Elektrizitätszähler 120 weiter mechanisch auf der Befestigungs- und Kontaktiereinrichtung neuerer Bauart gesichert werden.

Wird in einer bestehenden Anlage ein existierender Elektrizitätszähler mit Strommesseinrichtung durch einen elektronischen Elektrizitätszähler 120 neuerer Bauart ohne Strommesseinrichtung ersetzt, so ist im Regelfall die Befestigungs- und Kontaktiereinrichtung 100 älterer Bauart ohne Strommesseinrichtung durch eine Befestigungs- und Kontaktiereinrichtung neuerer Bauart mit Strommesseinrichtung auszutauschen. Um diesen erheblichen konstruktiven Aufwand beim Tauschen des Elektrizitätszählers zu vermeiden, wird gemäß dieser Anmeldung eine Adaptervorrichtung 10 vorgeschlagen, die eine erste Befestigungsfläche 20 zur Befestigung des elektronischen Elektrizitätszählers 120 und eine zweite Befestigungsfläche 40 zur Befestigung an der Befestigungs- und Kontaktiereinrichtung 100 umfasst. Die Adaptervorrichtung 10 umfasst ferner zwei erste Kontaktelemente 60, die von der zweiten Befestigungsfläche 40 vorstehen und die jeweils mit einem Anschlusselement der Befestigungs- und Kontaktiereinrichtung 100 verbindbar sind. Die Adaptervorrichtung 10 weist ferner wenigstens ein elektrisches Leitelement 62 auf, welches die zwei ersten Kontaktelemente 60 elektrisch leitend miteinander verbindet. Zudem weist die Adaptervorrichtung 10 wenigstens eine Strommesseinrichtung auf, welche benachbart zu dem elektrischen Leitelement 62 angeordnet ist, und umfasst wenigstens zwei zweite Kontaktelemente, die jeweils mit einem Anschlusselement 124 des elektronischen Elektrizitätszählers 120 verbindbar sind.

Die Strommesseinrichtung umfasst eine Signalleitung, die mit den wenigstens zwei zweiten Kontaktelementen elektrisch leitend verbunden ist. Die Strommesseinrichtung ist geeignet, auf der ersten Signalleitung ein elektrisches Signal bereit zu stellen, welches die in dem elektrischen Leitelement 62 fließende Stromstärke abbildet. Die Adaptervorrichtung 10 weist an der ersten Befestigungsfläche 20 eine Öffnung 22 auf, die derart ausgebildet ist, dass eine die Anschlusselemente 124 des elektronischen Elektrizitätszählers 120 aufweisende Anschlussleiste 122 beim Befestigen des elektronischen Elektrizitätszählers 120 mit der ersten Befestigungsfläche 20 in die Öffnung 22 einführbar ist, um die zweiten Kontaktelemente mit den Anschlusselementen 124 des elektronischen Elektrizitätszählers 120 elektrisch leitend zu verbinden.

Gemäß dem Ausführungsbeispiel kann die Strommesseinrichtung als Stromwandler 80 ausgebildet sein.

Die erste Befestigungsfläche 20 und die Öffnung 22 können derart ausgebildet sein, dass der elektronische Elektrizitätszähler 120 durch eine Verschiebebewegung parallel und/oder entlang der ersten Befestigungsfläche 20 mechanisch mit der ersten Befestigungsfläche 20 verbindbar ist. Die zweiten Kontaktelemente können derart ausgebildet sein, dass die Anschlusselemente 124 des elektronischen Elektrizitätszählers 120 durch eine Verschiebebewegung parallel und/oder entlang der ersten Befestigungsfläche 20 jeweils elektrisch leitend mit einem der zweiten Anschlusselemente verbindbar ist.

Vorzugsweise weist die Adaptervorrichtung 10 einen Stromwandler 80 pro zu messender Stromphase auf. Die Adaptervorrichtung 10 kann auch als Wandlersteckplatte (WSP) bezeichnet werden.

In einer bevorzugten Ausgestaltung kann die Adaptervorrichtung 10 eine Spannungsabgriffseinrichtung umfassen. Vorzugsweise umfasst die Spannungsabgriffseinrichtung wenigstens ein Spannungsabgriffselement, weiterhin vorzugsweise ein Spannungsabgriffselement für jede der zu messenden Stromphasen.

Das Spannungsabgriffselement oder jedes Spannungsabgriffselement kann von der zweiten Befestigungsfläche 40 vorstehen, um mit einem entsprechenden Element der Befestigungs- und Kontaktiereinrichtung 100, das in elektrisch leitendem Kontakt mit einem der Phasenleiter 106 und/oder dem Neutralleiter 108 steht und an welchen dieselbe Spannung wie der Phasenleiter 106 und/oder der Neutralleiter 108 anliegt, in elektrisch leitendem Kontakt gebracht zu werden.
Vorzugsweise erstrecken sich die zweiten Kontaktelemente im Wesentlichen entlang einer Richtung, die im Wesentlichen parallel zur ersten Befestigungsfläche 20 verläuft. Die zweiten Kontaktelemente können als Kontakthülsen ausgebildet sein, in welche stiftförmige Anschlusselemente 124 des elektronischen Elektrizitätszählers 120 aufnehmbar sind, um die zweiten Kontaktelemente elektrisch leitend mit den Anschlusselementen 124 des elektronischen Elektrizitätszählers 120 zu verbinden.

Vorzugsweise ist die erste Befestigungsfläche 20 an einer Vorderseite 12 der Adaptervorrichtung 10 angeordnet. Vorzugsweise ist die zweite Befestigungsfläche 40 an einer Rückseite 14 der Adaptervorrichtung 10 angeordnet. Weiterhin vorzugsweise ist die Öffnung 22 rechteckig ausgebildet und an der Vorderseite 12 angeordnet.

Die Adaptervorrichtung 10 kann ein Aufnahmeelement 11 zur Aufnahme eines durch eine Aufnahme 121 des elektronischen Elektrizitätszählers 120 geführten Plombierungsbolzens 130 aufweisen, wobei das Aufnahmeelement 11 an der ersten Befestigungsfläche 20 angeordnet sein kann und geeignet sein kann, den Plombierungsbolzen 130 derart aufzunehmen, dass der elektronische Elektrizitätszähler 120 gegen eine Verschiebung in einer im Wesentlichen parallel zur ersten Befestigungsfläche 20 verlaufenden Richtung auf der ersten Befestigungsfläche 20 gehalten ist.

Die Adaptervorrichtung 10 kann ferner wenigstens ein Verhakungselement 42 umfassen, das von der zweiten Befestigungsfläche 40 vorspringt und geeignet ist, einen Abschnitt der Befestigungs- und Kontaktiereinrichtung 100, der im Wesentlichen durch einen Einschnitt 113 in der Befestigungs-und Kontaktiereinrichtung 100 gebildet ist, zu hintergreifen, um die zweite Befestigungsfläche 40 und/oder die Adaptervorrichtung 10 mechanisch mit der Befestigungs- und Kontaktiereinrichtung 100 zu verbinden.

Der Elektrizitätszähler 120 kann zudem ferner ebenfalls wenigstens ein Verhakungselement 123 umfassen, das von einer Rückseite des Elektrizitätszählers 120 vorspringt und geeignet ist, einen Abschnitt der Adaptervorrichtung 10, der im Wesentlichen durch einen Einschnitt 13 in der Adaptervorrichtung 10 gebildet ist, zu hintergreifen, um die zweite Befestigungsfläche 40 und/oder die Adaptervorrichtung 10 mechanisch mit der Befestigungs- und Kontaktiereinrichtung 100 zu verbinden.

Die ersten Kontaktelementen 60 können als Kontaktmesser ausgebildet sein, die in Kontaktöffnungen 102 der Befestigungs- und Kontaktiereinrichtung 100 durch eine Einführbewegung in einer im Wesentlichen orthogonal zur zweiten Befestigungsfläche 40 verlaufenden Einrichtung einführbar sein. Die ersten Kontaktelemente 60 können durch eine Verschiebebewegung im Wesentlichen orthogonal zur Einführrichtung elektrisch leitend mit den Anschlusselementen der Befestigungs- und Kontaktiereinrichtung 100 verbindbar sein.

Die Anmeldung betrifft ferner eine Elektrizitätszählereinheit, welche einen elektronischen Elektrizitätszähler 120 und eine Adaptervorrichtung 10 umfasst. Der elektronische Elektrizitätszähler 120 ist an der ersten Befestigungsfläche 20 befestigt. Eine Anschlusselemente 124 des elektronischen Elektrizitätszählers 120 aufweisende Anschlussleiste 122 des elektronischen Elektrizitätszählers 120 ist in die Öffnung 22 eingeführt und die zweiten Kontaktelemente sind mit den Anschlusselementen 124 des Elektrizitätszählers 120 elektrisch leitend verbunden.

Die Strommesseinrichtung und/oder der Stromwandler können ein Signal auf der ersten Signalleitung bereitstellen, das die in dem elektrischen Leitelement 62 fließende Stromstärke abbildet. Insbesondere kann das Signal in der ersten Signalleitung mit einer Stromstärke fließen, die einem Bruchteil der in dem entsprechenden Phasenleiter 106 fließenden Stromstärke entspricht. Das heißt, dass in diesem Falle die in der ersten Signalleitung fließende Stromstärke mit einem Faktor multipliziert werden muss, um die in dem elektrischen Leitelement 62 fließende Stromstärke zu erhalten. Hierzu kann der Faktor in einem Speichermodul des elektronischen Elektrizitätszählers 120 gespeichert sein, und ein Steuerungsmodul des Elektrizitätszählers 120 kann auf diesen Faktor zugreifen, um die tatsächlich in dem elektrischen Leitelement 62 fließende Stromstärke bestimmen und beispielsweise einem Benutzer anzeigen zu können. Alternativ oder zusätzlich kann der Faktor auch mittels einer Stellschraube 140 an dem Elektrizitätszähler 120 eingestellt werden und/oder durch das elektrische Signal und/oder das Funksignal und/oder das optische Signal zusätzlich abgebildet werden. Die Stellschraube 140 kann mittels einer zweiten Plombierung 142 verplombt werden.

Vorzugsweise kann die erste Befestigungsfläche 20 eine optische Schnittstelle 26 zur Übertragung des die in dem elektrischen Leitelement 62 fließende Stromstärke abbildende optische Signal an eine entsprechende Schnittstelle des Elektrizitätszählers 120.

Selbstverständlich ist die Erfindung nicht auf die beschriebenen und dargestellten Ausführungsformen begrenzt. Änderungen, z. B. in den Ausführungsformen der verschiedenen Bestandteile oder Ersetzungen durch technische Äquivalente sind, soweit sie im Rahmen des beanspruchten Schutzbegehrens bleiben, jederzeit möglich.

## Patentansprüche

1. Adaptervorrichtung zum mechanischen und elektrischen Verbinden eines elektronischen Elektrizitätszählers (120) mit einer Befestigungs- und Kontaktiereinrichtung (100) eines Zählerplatzes, umfassend
eine erste Befestigungsfläche (20) zur Befestigung des elektronischen Elektrizitätszählers (120),
eine zweite Befestigungsfläche (40) zur Befestigung an der Befestigungs- und Kontaktiereinrichtung (100),
wenigstens zwei erste Kontaktelemente (60), die von der zweiten Befestigungsfläche (40) vorstehen und die jeweils mit einem Anschlusselement der Befestigungs- und Kontaktiereinrichtung (100) verbindbar sind,
wenigstens ein elektrisches Leitelement (62), welches die zwei ersten Kontaktelemente (60) elektrisch leitend miteinander verbindet, und
wenigstens eine Strommesseinrichtung, welche benachbart zu dem elektrischen Leitelement (62) angeordnet ist,
wobei die Strommesseinrichtung geeignet ist, ein elektrisches Signal und/oder ein Funksignal und/oder ein optisches Signal dem Elektrizitätszähler (120) bereit zu stellen, welches die in dem elektrischen Leitelement (62) fließende Stromstärke abbildet.

2. Adaptervorrichtung nach Anspruch 1, **gekennzeichnet durch** wenigstens eine Signalübertragungseinrichtung,
wobei die Strommesseinrichtung eine erste Signalleitung umfasst, die elektrisch leitend mit der Signalübertragungseinrichtung verbunden ist,
wobei die Strommesseinrichtung geeignet ist, auf der ersten Signalleitung ein elektrisches Signal bereit zu stellen, welches die in dem elektrischen Leitelement (62) fließende Stromstärke abbildet, und
wobei die Signalübertragungseinrichtung geeignet ist, anhand des elektrischen Signals ein Funksignal und/oder ein optisches Signal zu erzeugen, welches die in dem elektrischen Leitelement (62) fließende Stromstärke abbildet und welches von einer Empfangseinrichtung des Elektrizitätszählers (120) Empfangen werden kann.

3. Adaptervorrichtung nach Anspruch 1, **gekennzeichnet durch** wenigstens zwei zweite Kontaktelemente, die jeweils mit einem Anschlusselement (124) des elektronischen Elektrizitätszählers verbindbar sind,
wobei die Strommesseinrichtung eine erste Signalleitung umfasst, die mit den wenigstens zwei zweiten Kontaktelementen elektrisch leitend verbunden ist,
wobei die Strommesseinrichtung geeignet ist, auf der ersten Signalleitung ein elektrisches Signal bereit zu stellen, welches die in dem elektrischen Leitelement (62) fließende Stromstärke abbildet,
wobei die Adaptervorrichtung (10) an der ersten Befestigungsfläche (20) eine Öffnung (22) aufweist, die derart ausgebildet ist, dass eine die Anschlusselemente (124) des elektronischen Elektrizitätszählers (120) aufweisende Anschlussleiste (122) beim Befestigen des elektronischen Elektrizitätszählers (120) mit der ersten Befestigungsfläche (20) in die Öffnung (22) einführbar ist, um die zweiten Kontaktelemente mit den Anschlusselementen (124) des Elektrizitätszählers elektrisch leitend zu Verbinden.

4. Adaptervorrichtung nach einem der Ansprüche 1 bis 3, **dadurch gekennzeichnet, dass** die Strommesseinrichtung als Stromwandler (80) ausgebildet ist.

5. Adaptervorrichtung nach einem der Ansprüche 3 oder 4, **dadurch gekennzeichnet, dass** die erste Befestigungsfläche(20) und die Öffnung (22) derart ausgebildet sind, dass der elektronische Elektrizitätszähler (120) durch eine Verschiebebewegung parallel und/oder entlang der ersten Befestigungsfläche (20) mechanisch mit der ersten Befestigungsfläche (20) verbindbar ist und/oder **dadurch, dass** die zweiten Kontaktelemente derart ausgebildet sind, dass die Anschlusselemente (124) des elektronischen Elektrizitätszählers durch eine Verschiebebewegung parallel und/oder entlang der ersten Befestigungsfläche (20) jeweils elektrisch leitend mit einem der zweiten Anschlusselemente verbindbar sind.

6. Adaptervorrichtung nach einem der Ansprüche 3 bis 5, **dadurch gekennzeichnet, dass** sich die zweiten Kontaktelemente im Wesentlichen entlang einer Richtung erstrecken, die im Wesentlichen parallel zur ersten Befestigungsfläche (20) verläuft.

7. Adaptervorrichtung nach einem der Ansprüche 3 bis 6, **dadurch gekennzeichnet, dass** die zweiten Kontaktelemente als Kontakthülsen ausgebildet sind, in welche stiftförmige Anschlusselemente (124) des elektronischen Elektrizitätszählers (120) aufnehmbar sind, um die zweiten Kontaktelemente elektrisch leitend mit den Anschlusselementen (124) des elektronischen Elektrizitätszählers (120) zu verbinden.

8. Adaptervorrichtung nach einem der Ansprüche 1 bis 7, **gekennzeichnet durch** ein Aufnahmeelement zur Aufnahme eines durch eine Aufnahme des elektronischen Elektrizitätszählers (120) geführten Plombierungsbolzens (130), wobei das Aufnahmeelement an der ersten Befestigungsfläche (20) angeordnet ist und geeignet ist, den Plombierungsbolzen (130) derart aufzunehmen, dass der elektronische Elektrizitätszähler (120) gegen eine Verschiebung in einer im Wesentlichen parallel zur ersten Befestigungsfläche (20) verlaufenden Richtung auf der ersten Befestigungsfläche (20) gehalten ist.

9. Adaptervorrichtung nach einem der Ansprüche 1 bis 8, **gekennzeichnet durch** ein Verhakungselement (42), das von der zweiten Befestigungsfläche (40) vorspringt und geeignet ist, einen Abschnitt der Befestigungs- und Kontaktiereinrichtung (100) zu hintergreifen, um die zweite Befestigungsfläche (40) und/oder die Adaptervorrichtung (10) mechanisch mit der Befestigungs- und Kontaktiereinrichtung (100) zu verbinden.

10. Adaptervorrichtung nach einem der Ansprüche 1 bis 9, **dadurch gekennzeichnet, dass** die ersten Kontaktelemente (60) als Kontaktmesser ausgebildet sind, die in Kontaktöffnungen (102) der Befestigungs- und Kontaktiereinrichtung (100) durch eine Einführbewegung in einer im Wesentlichen orthogonal zur zweiten Befestigungsfläche (40) verlaufenden Einführrichtung einführbar sind und durch eine Verschiebebewegung im Wesentlichen orthogonal zur Einführrichtung elektrisch leitend mit den Anschlusselementen der Befestigungs- und Kontaktiereinrichtung (100) verbindbar sind.

11. Elektrizitätszählereinheit umfassend einen elektronischen Elektrizitätszähler (120) und eine Adaptervorrichtung (10) nach einem der Ansprüche 1 bis 10, **dadurch gekennzeichnet, dass** der elektronische Elektrizitätszähler (120) an der ersten Befestigungsfläche (20) befestigt ist.
